# EUROPEAN PATENT APPLICATION

(11) **EP 1 630 866 A1**
(43) Date of publication of application: **01.03.2006**
(21) Application number: 04103946.2
(22) Date of filing: 17.08.2004
(51) Int. Cl.: H01L 23/495, H01L 21/56

(54) **Packaging method for integrated circuits**

(71) Applicant: OPTIMUM CARE INTERNATIONAL TECH. INC., Neihu District, Taipei City 114 (TW)
(72) Inventor: Lien, Jeffrey, Shihlin District 111 Taipei City (CN)
(74) Representative: Schmitz, Jean-Marie

(57) **Abstract**

A packaging method for integrated circuits comprising processes such as wafer grinding, wafer mount, wafer saw, die attach, etc., multiple singulated chips are each attached and assembled to leadframe unit, the leadframe unit is used as electrical out-connecting component for each chip, and the wire-bonding part of the chip is dispensed continuously with encapsulant material to seal, curing method is further applied to solidify the encapsulant, then saw or punching method is used to dice apart each chip accompanied with leadframe unit (singulation process), a ready-to-use integrated circuit is thus obtained, such manufacturing processes let the goals of easy-to-manufacture, fast production and lowered production cost be easily achieved for the packaging and singulating processes.

## Description

### BACKGROUND OF THE INVENTION

### 1. Field of the Invention:

This invention relates to a packaging method for integrated circuits, it more specifically relates to an integrated circuit packaging method and design comprising methods and processes such as assembly of chip and leadframe, wire-bonding, globtopping, curing, and singulation.

### 2. Description of the Related Art:

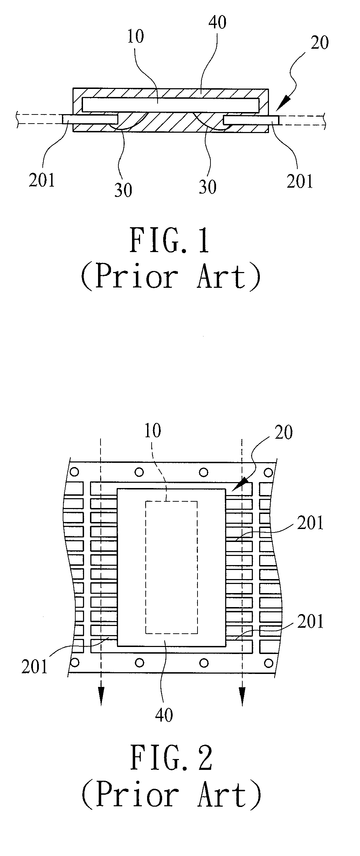

The prior art integrated circuit structure is as shown in figure 1, a singulated chip 10 is attached to leadframe unit 20, wherein said leadframe unit 20 comprising of multiple rows of leads 201, at the selected surface of leads 201 and chip 10 is wire-bonded with wire 30, leads 201 are used as the out-connecting components for chip 10; since wire 30 is very delicate, it is commonly sealed through packaging method in the prior art to prevent its damage from external forces, that is, mold is used to enclose chip 10 and leadframe unit 20, then insulating encapsulant is injected into the mold such that an encapsulated body 40 is formed to enclose chip 10 and leadframe unit 20 ; furthermore, as shown in figure 2, the packaged integrated circuit is singulated to separate the chip for use by other end users.

In the prior art packaging method, Transfer Molding method has to be used, therefore, multiple types and sizes of mold have to be prepared, the packaging cost thus can not be lowered, and too many molds could also cause QC troubles; furthermore, when the mold enclose chip 10 and leadframe 20, the gaps among leads 201 are not blocked, therefore, when encapsulant is injected under high pressure, encapsulant usually overflows outside leadframe 20, this could cause defect in the packaged product; if any stop component is used to stop the overflow of encapsulant among leads 201, it would be technically very difficult since leads 201 of leadframe unit 20 are very delicate, not only a lot of trouble could be encountered in the process, it could also bring damage to leads 201. Moreover, in the prior art, integrated circuit is singulated to separate (to exclude leadframe and other junk material), therefore, only one by one dicing can be performed (please refer to figure 2), and the efficiency during mass production is thus reduced.

### SUMMARY OF THE INVENTION

The main purpose of this invention is to provide a packaging method and design for integrated circuit, it is an integrated circuit packaging method and design comprising methods and processes such as assembly of chip and leadframe, wire-bonding, globtopping, curing, and singulation, the goals of easy manufacturing processes, fast production, lowering production cost, easy-to-control integrated circuit quality, suitability for mass production, etc.

To achieve the above-mentioned goals, this invention is embodied through processes such as: wafer grinding, wafer mount, wafer saw, dice attach and wire-bonding, multiple singulated die (chips) are each attached and assembled to leadframe unit of the leadframe, multiple leads of the leadframe unit is used as electrical out-connecting component for each chip, and the wire-bonding part of the chip is dispensed continuously with encapsulant material to seal, curing method is further applied to solidify the encapsulant, then saw or punching method is used to dice apart each chip accompanied with leadframe unit (singulation process), a ready to use integrated circuit is thus obtained, such manufacturing processes let the goals of easy to manufacture, fast production, lowered production cost, easy-to-control integrated circuit quality, suitability for mass production, etc. be easily achieved.

### BRIEF DESCRIPTION OF THE DRAWINGS

Figure 1 is the cross section view of the composition and structure of prior art integrated circuits.
Figure 2 shows a separation diagram of a prior art integrated circuit with other parts of a leadframe.
Figure 3 shows the flow charts for packaging processes for the integrated circuits of the current invention.
Figure 4 is the wafer mount process of the current invention.
Figure 5 shows the structure of leadframe and leadframe unit for the current invention.
Figure 6 is the wire-bonding manufacturing process for the current invention.
Figure 7 is the globtopping manufacturing process for the current invention.
Figure 8 is the singulating manufacturing process for the current invention.
Figure 9 shows the cross sectional view of the integrated circuits composition and structure for the current invention.
Figure 10 shows the bottom view stereo drawing of the integrated circuits composition and structure for the current invention.
Figure 11 shows the embodiment of encapsulant dispensing for the current invention.

### DETAILED DESCRIPTION OF THE INVENTION

The structure features and other functions and purposes of this invention will be described in details in the followings accompanied with the embodiments in the attached figures:

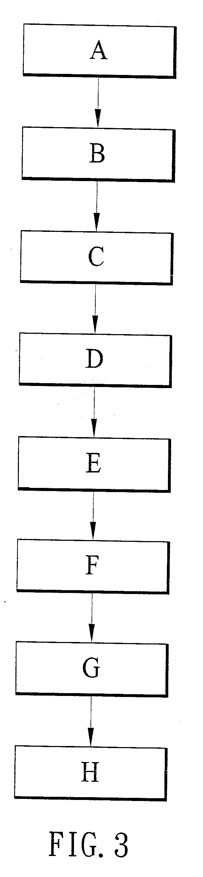

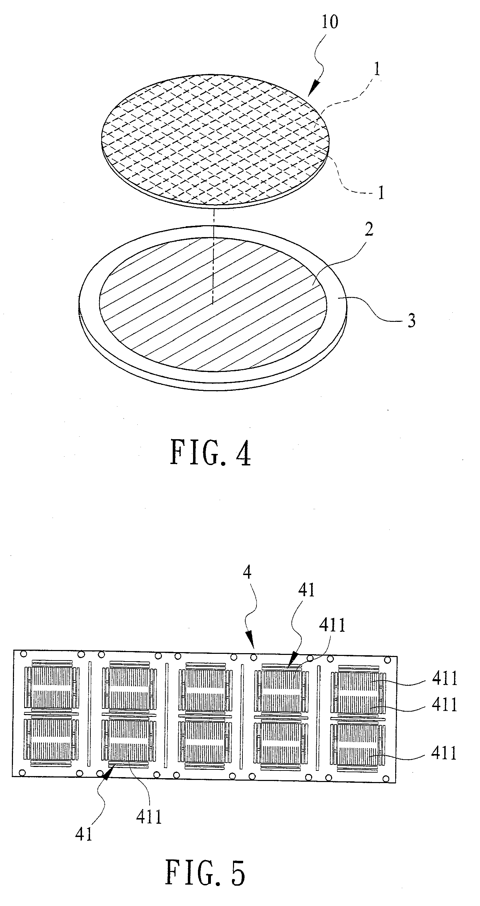

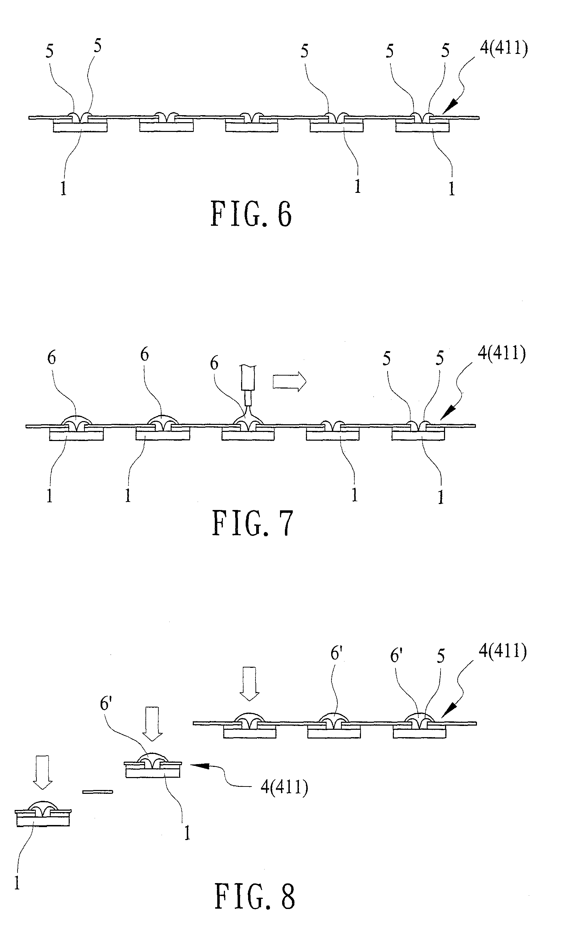

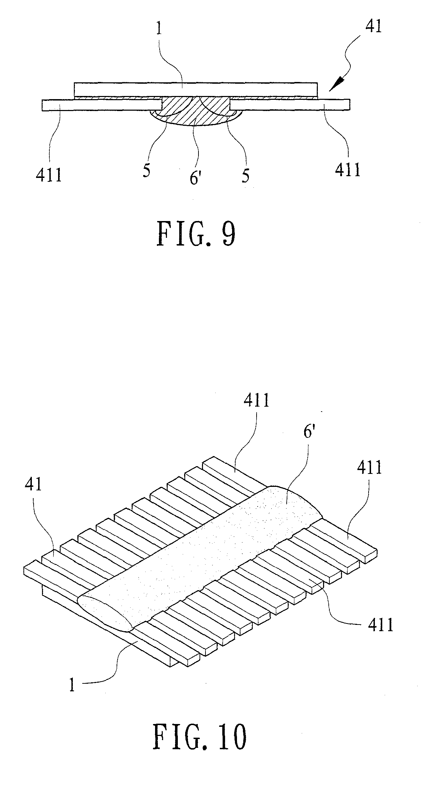

As shown in the attached figure, this invention is related to "packaging method of integrated circuit", it could be assembled for electronic products, it is a packaging method and structure design for integrated circuit which possesses special function, please refer to figure 3 for its packaging processes, comprising of:
(A) Wafer grinding: Grinding is performed on sliced round wafer 10, its thickness is controlled within product spec; but wafer 10 grinding depends on actual needs, some wafers do not need grinding;
(B) Wafer mount: As shown in figure 4, the above-mentioned grinding finished wafer or no-need grinding wafer 10 is temporarily fixed to metal frame 3 (ring) through adhesive 2 (such as blue tape) for further process operations;
(C) Wafer saw: Dicing saw is commonly used to dice the wafer to form multiple independent units of chips 1 temporarily attached to the tape of the metal frame (ring);
(D) Die attach: The singulated chips 1 are transferred to the leadframe units 41 of the leadframe 4 through pick and place device, and chip 1 is attached to leadframe unit 41 through adhesive (such as tape or adhesive glue); for the leadframe 4 and leadframe unit 41, please refer to figure 5, thin plate (such as copper plate) is pressed continuously on its surface to form multiple leadframe units 41, each leadframe unit 41 comprising of temporarily un-separated multiple rows of leads 411, these leads 411 are used as out-connecting conducting components for chip 1;
(E) Wire-bonding: As shown in figure 6, metal wire 5 (such as gold wire) is wire-bonded to the electrical contacts of chip 1 and the inner end selected spots of leads 411 respectively through wire-bonder such that chip 1 can be connected to outside electrically through leads 411;
(F) Globtopping: Please refer to figure 7, metallic wire 5 is used to electrically out-connect chip 1 to outside, liquid type encapsulant material 6 (insulating material) is dispensed continuously to seal the electrical connecting part of metallic wire 5;
(G) Curing: The above dispensed encapsulant 6 is then sent to oven for curing in appropriate temperature, encapsulant 6 is further solidified to form encapsulated body 6', encapsulated body 6' then seal the electrical connecting part of metallic wire 5 (please refer to figure 9 and figure 10), and the outer ends of leads 411 of the leadframe unit 41 are then exposed;
(H) Saw: Please refer to figure 8, saw or punching process with dicing wheel or punching tool can then be applied to the packaged products to cut away unwanted material at the outer ends of leads 411 of leadframe unit 41, and each independent unit is thus separated, each integrated circuit unit comprising of chip 1, leadframe unit 41, leads 411, metallic wire 5 and encapsulated body 6', it can be used in specific electronic product;

The integrated circuit structure of the current invention, through the above-mentioned packaging method and design, as shown in figure 9 and 10, comprising a specific function die 1 (chip), at its bottom is a leadframe unit 41 with multiple rows of leads 411, metallic wire 5 is used between chip 1 and leads 411 as electrical connection, the electrical connecting part of metallic wire 5 is sealed with encapsulated body 6', the outer ends and bottom surfaces of leads 411 are used as connecting part to the printed circuit board, it thus forms integrated circuit which can be applied and soldered to all kinds of electronic products.

The disclosed "globtopping" (F) process for the current invention is to use liquid encapsulant material 6 melted to certain viscosity and dispense it directly to seal the electrical connecting part of metallic wire 5, then it is solidified to form encapsulated body 6' through curing at appropriate temperature, the encapsulated body 6' can thus protect the electrical connecting part of metallic wire 5; through the embodiment of this process, it can save the use of prior art molding equipment, and the goals of easy manufacturing processes, fast production, lowered production cost, easy-to-control integrated circuit quality, suitability for mass production can thus be achieved. Furthermore, since in the "singulation" (H) process of the current invention, we use punch tool to punch independent unit of integrated circuit, and get away the excess material of leadframe 4, therefore, through the design of punching mold, we can punch multiple integrated circuits at a time, this can improve the prior art which dice the die one by one, and the manufacturing of integrated circuit products can thus be speeded up, this is a process very suitable for mass production.

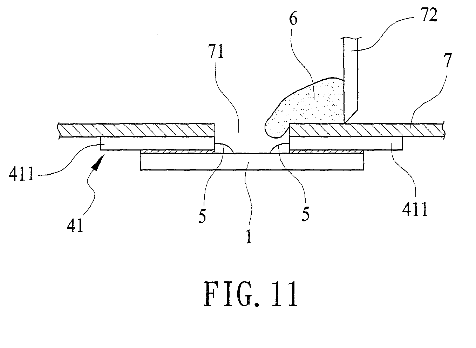

We also have to point out, the "globtopping" (F) process disclosed in this invention can also be embodied by "coating" method, please refer to figure 11, it is to first embody wire-bonding on one side of the chip 1 to form electrical out-connecting part (surface), then a plate 7 is covered in advance, the plate 7 has at least an opening 71 corresponding to the electrical out-connecting part of metallic wire 5, therefore, encapsulant material 6 can be placed above the plate 7, then a scrape blade 72 can be used to transfer encapsulant material 6 to fill the opening 71, encapsulant material therefore seal the electrical connecting part of the metallic wire, then plate 7 is taken away , a "curing" (G)process is embodied ,a structure where encapsulated body 6' seal the electrical connecting part of metallic wire 5 is thus formed ,other later process such as singulation (H), etc., can thus be performe, independent unit of integrated circuit can thus be produced; therefore, a manufacturing method adopting plate 7 accompanied with scrape blade 72 for "coating" can avoid the use of prior art Transfer Mold equipment and tooling ,the goals of easy manufacturing processes, fast production, lowered production cost, easy-to-control integrated circuit quality, suitability for mass production can thus be achieved.

Summarize the above descriptions, current invention of "Packaging method for integrated circuits" does possess the required properties of utility and invention, its embodiments are also inventive, we therefore submit a new type patent application.

## Claims

1. A packaging method for integrated circuits comprising in sequence the following processes: Wafer grinding, wafer mount, wafer saw, die attach, wire-bonding, multiple chips are separately fixed to the leadframe units of leadframe, said leadframe unit comprising multiple rows of leads; metallic wires are used to connect the electrical contacts on the chip and the leads of the leadframe unit for the purpose of further packaging operations, its main features include: further packaging operations include:
(a) Select the embodied wire-bond area which forms an electrically out-connecting on the chip to use liquid encapsulant in melted status and of appropriate viscosity for globtopping, the electrically out-connecting part of metallic wire can thus be sealed;
(b) Then apply curing of appropriate temperature to the dispensed encapsulant material to solidify the encapsulant into encapsulated body;
(c) Finally, punching tool and method are used to cut away the excessive materials on the outer ends of the leads of the leadframe unit, and an integrated circuit is then separated with structure comprising of chip, leadframe unit, multiple leads, metallic wires and encapsulated body.

2. The packaging method for integrated circuits of claim 1 wherein packaging operations include wire-bonding on one side of the chip to form electrical out-connecting part, then a plate is covered in advance, the plate has an opening corresponding to the electrical out-connecting part of metallic wire, therefore, encapsulant material can be placed above the plate, and a scrape blade can be used to transfer encapsulant material to fill the opening, encapsulant material therefore seal the area of electrical connecting part of the metallic wire.
